# EUROPÄISCHE PATENTSCHRIFT

(11) **EP 1 125 202 B1**
(45) Veröffentlichungstag und Bekanntmachung des Hinweises auf die Patenterteilung: **18.06.2003**
(21) Anmeldenummer: 99924818.0
(22) Anmeldetag: 19.04.1999
(51) Int. Cl.: G06F 11/18, G06F 11/00, G11C 29/00, G06F 11/10

(54) **SPEICHEREINRICHTUNG ZUM SPEICHERN VON DATEN UND VERFAHREN ZUM BETREIBEN VON SPEICHEREINRICHTUNGEN ZUM SPEICHERN VON DATEN**
STORAGE DEVICE FOR STORING DATA AND METHOD FOR OPERATING STORAGE DEVICES FOR DATA STORAGE
DISPOSITIF DE MEMORISATION POUR STOCKER DES DONNEES ET PROCEDE POUR FAIRE FONCTIONNER DES DISPOSITIFS DE MEMORISATION POUR STOCKER DES DONNEES

(30) Priorität: 30.10.1998 US 106370 P
(43) Veröffentlichungstag der Anmeldung: 22.08.2001
(73) Patentinhaber: Infineon Technologies AG, 81669 München (DE)
(72) Erfinder: KLIEGELHÖFER, Peter, D-81827 München (DE); PÖPPEL, Gerhard, D-93049 Regensburg (DE); STEURICH, Björn, D-80797 München (DE); ULLMANN, Rudolf, D-85521 Ottobrunn (DE); VERBECK, Michael, D-81827 München (DE)
(74) Vertreter: Jannig, Peter, Dipl.-Ing.
(86) Internationale Anmeldenummer: EP9902761
(87) Internationale Veröffentlichungsnummer: WO00026783

(56) Entgegenhaltungen:
- EP-A- 0 615 211
- EP-A- 0 753 815
- DE-A- 3 134 995
- US-A- 4 183 463
- US-A- 5 475 693
- PATENT ABSTRACTS OF JAPAN vol. 007, no. 212 (P-224), 20. September 1983 (1983-09-20) & JP 58 105498 A (FUJITSU KK), 23. Juni 1983 (1983-06-23)
- CHARPENTIER PH ET AL: "CONTROLE D'INTEGRITE DU CONTENU D'UNE MEMOIRE PROGRAMME: ETUDE COMPARATIVE DU CRC ET DU CHECKSUM" ONDE ELECTRIQUE,FR,EDITIONS CHIRON S.A. PARIS, Bd. 71, Nr. 2, 1. März 1991 (1991-03-01), Seiten 52-57, XP000224182 ISSN: 0030-2430
- PATENT ABSTRACTS OF JAPAN vol. 007, no. 138 (P-204), 16. Juni 1983 (1983-06-16) & JP 58 053090 A (FUJITSU KK), 29. März 1983 (1983-03-29)

## Beschreibung

Die vorliegende Erfindung betrifft ein Verfahren gemäß dem Oberbegriff des Patentanspruchs 1 und eine Vorrichtung gemäß dem Oberbegriff des Patentanspruchs 3, d.h. ein Verfahren zum Betreiben einer Speichereinrichtung zum Speichern von Daten und eine Speichereinrichtung zum Speichern von Daten.

Bei der Speichereinrichtung handelt es sich beispielsweise um Halbleiterspeicher wie RAMs, ROMs, EPROMs, EEPROMs, Flash-Speicher etc., aber auch um Magnetspeicher, optische Speicher oder sonstige Speichereinrichtungen. Speichereinrichtungen dieser Art sind bekannt und bedürfen keiner näheren Erläuterung.

Bei allen Speichereinrichtungen kommt es mehr oder weniger häufig vor, daß die darin gespeicherten Daten nicht den ursprünglich eingespeicherten Daten entsprechen. Mögliche Gründe hierfür sind, daß die die Daten speichernden Speicherelemente teilweise defekt sind, und daß auch intakte Speicherelemente im Lauf der Zeit selbständig ihren Inhalt verändern können. Dies ist verständlicherweise ein Nachteil, dessen Beseitigung überaus wünschenswert ist.

Bisher begegnet man solchen Speicherfehlern oder Speicherinhältsveränderungen, indem man nicht die eigentlich zu speichernden Daten selbst in die Speichereinrichtung einschreibt, sondern die zu speichernden Daten erst konvertiert und die daraus resultierenden (konvertierten) Daten in die Speichereinrichtung einschreibt, wobei die konvertierten Daten so beschaffen sind, daß sich aus ihnen selbst dann, wenn sie fehlerbehaftet sind, die ursprünglichen Daten rekonstruieren lassen. Eine derartige Handhabung von Speicherfehlern oder Speicherinhaltsveränderungen ist erkennbar mit einem sehr hohen Aufwand verbunden.

Aus der EP-A-0 753 815 sind ein Verfahren zum Betreiben einer Speichereinrichtung und eine Speichereinrichtung bekannt, bei welcher in der Speichereinrichtung zu speichernde Daten mehrfach in der Speichereinrichtung gespeichert werden, und wobei die ursprünglich eingespeicherten Daten bei Bedarf aus den mehrfach gespeicherten Daten rekonstruiert werden. Hierbei werden diejenigen Daten als die ursprünglich eingespeicherten Daten angesehen, die unter den mehrfach gespeicherten Daten am öftesten vorhanden sind. Diese Art der Rekonstruktion der ursprünglich eingespeicherten Daten ist zwar relativ einfach realisierbar, funktioniert dafür aber nicht immer zuverlässig; es besteht eine gewisse Wahrscheinlichkeit, daß die ursprünglich eingespeicherten Daten falsch rekonstruiert werden.

Der vorliegenden Erfindung liegt daher die Aufgabe zugrunde, Möglichkeiten zum schnellen und einfachen Umgang mit möglicherweise vorhandenen oder noch auftretenden Speicherfehlern und Speicherinhaltsveränderungen zu finden.

Diese Aufgabe wird erfindungsgemäß durch das in Patentanspruch 1 beanspruchte Verfahren und die in Patentanspruch 3 beanspruchte Merkmale Speichereinrichtung gelöst.

Das in Patentanspruch 1 beanspruchte Verfahren und die in Patentanspruch 3 beanspruchte Vorrichtung zeichnen sich dadurch aus, daß die Rekonstruktion der ursprünglich in die Speichereinrichtung eingespeicherten Daten unter Berücksichtigung der Richtung von gegebenenfalls vorkommenden Speicherinhaltsveränderungen erfolgt.

Damit lassen sich die ursprünglich in die Speichereinrichtung einzuspeichernden Daten ohne komplizierte Umsetzungen, also schnell und einfach, und darüberhinaus sehr zuverlässig richtig rekonstruieren.

Möglicherweise vorhandene oder noch auftretende Speicherfehler und Speicherinhaltsveränderungen lassen sich so denkbar einfach und mit minimalem Aufwand handhaben.

Vorteilhafte Weiterbildungen der Erfindung sind den Unteransprüchen, der nachfolgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: eine schematische Darstellung zur Erläuterung einer ersten Möglichkeit zur Handhabung von möglicherweise fehlerhaften oder veränderten Speicherinhalten, und
- Figur 2: eine schematische Darstellung zur Erläuterung einer zweiten Möglichkeit zur Handhabung von möglicherweise fehlerhaften oder veränderten Speicherinhalten.

Bei den nachfolgend näher betrachteten Speichereinrichtungen handelt es sich um Flash-Speicher. Es sei jedoch bereits an dieser Stelle darauf hingewiesen, daß es sich bei der Speichereinrichtung grundsätzlich auch um einen anderen Halbleiterspeicher wie beispielsweise ein RAM, ein ROM, ein EPROM, ein EEPROM, aber auch um einen Magnetspeicher, einen optischen Speicher oder einen sonstigen Speicher handeln kann.

Der Flash-Speicher ist im betrachteten Beispiel Bestandteil eines Mikrocontrollers. Auch hierauf besteht keine Einschränkung. Die betrachtete Speichereinrichtung kann auch Bestandteil beliebiger anderer Vorrichtungen oder eine eigenständige Speichereinrichtung sein.

Flash-Speicher und andere Speichereinrichtungen weisen bekanntlich den Nachteil auf, daß in diese eingeschriebene Daten mitunter falsch sind, weil einzelne Speicherelemente defekt sind und/oder weil auch in intakten Speicherelemente gespeicherte Daten mit der Zeit selbständig ihren Inhalt ändern.

Nachfolgend werden einige praktisch sehr einfach realisierbare Möglichkeiten zur schnellen, einfachen, und gleichwohl zuverlässigen Handhabung von möglicherweise fehlerhaften und/oder veränderten Speicherinhalten vorgestellt.

Vorab sei hierzu angemerkt, daß die Art der Handhabung von möglicherweise fehlerhaften und/oder veränderten Speicherinhalten von der jeweiligen Situation abhängt. Insbesondere wenn in der Speichereinrichtung gespeicherte Daten ausgelesen werden, weil sie gerade von einer anderen Systemkomponente benötigt werden, muß "nur" dafür gesorgt werden, daß die ausgegebenen Daten die ursprünglich in die Speichereinrichtung eingeschriebenen Daten sind, also fehlerfrei und unverändert sind. Hierzu ist es, wie später noch genauer beschrieben wird, nicht notwendig, Fehler und Veränderungen von Daten zu erkennen und/oder in der Speichereinrichtung zu korrigieren. Dies kann zu einem späteren Zeitpunkt erfolgen oder eventuell ganz unterbleiben. Andererseits kann, wie später ebenfalls noch genauer beschrieben werden wird, vorgesehen werden, den Speicherinhalt bereits dann zu korrigieren (aufzufrischen), wenn noch gar kein Fehler und gar keine Veränderung der Daten stattgefunden hat, sondern erst demnächst zu erwarten ist.

Überprüfungen und/oder Korrekturen der in der Speichereinrichtung gespeicherten Daten können zu beliebigen Zeitpunkten und/oder im Ansprechen auf beliebige Ereignisse erfolgen. Bei zeitgesteuerter Durchführung der Überprüfung und/oder Korrektur kann vorgesehen werden, daß eine Überprüfung und/oder eine Korrektur zu bestimmten Zeitpunkten und/oder spätestens dann durchgeführt wird, wenn seit der letzten Überprüfung und/oder Korrektur eine vorbestimmte Zeit vergangen ist. Bei ereignisgesteuerter Durchführung der Überprüfung und/oder Korrektur kann beispielsweise vorgesehen werden, die Überprüfung und/oder Korrektur bei der Inbetriebnahme und/oder beim Ausschalten und/oder bei Betriebsartwechseln (beispielsweise beim Wechsel von der "Normal"-Betriebsart in den sogenannten Sleep-Mode und/oder umgekehrt) der Speichereinrichtung oder der diese enthaltenden Vorrichtung durchzuführen.

Die erste der genannten Möglichkeiten zur Handhabung von möglicherweise fehlerhaften oder veränderten Speicherinhalten besteht darin, daß die in der Speichereinrichtung zu speichernden Daten mehrfach in dieser gespeichert werden, und daß die ursprünglich eingespeicherten Daten bei Bedarf aus den mehrfach gespeicherten Daten rekonstruiert werden.

Beispielsweise kann vorgesehen werden, die zu speichernden Daten insgesamt drei Mal in der Speichereinrichtung zu speichern. Ein unter einer Adresse x zu speicherndes Datum wird dann beispielsweise nicht nur unter der Adresse x, sondern automatisch zusätzlich unter der Adresse x+m und unter der Adresse x+2m gespeichert.

Wenn die gespeicherten Daten aus der Speichereinrichtung ausgegeben oder auf Fehlerfreiheit bzw. Unverändertheit überprüft und gegebenenfalls korrigiert werden sollen, werden die ursprünglich in die Speichereinrichtung eingespeicherten Daten aus den mehrfach gespeicherten Daten rekonstruiert. Dabei werden die einander entsprechenden Daten (im betrachteten Beispiel die unter den Adressen x, x+m und x+2m gespeicherten Daten) gelesen und bitweise ausgewertet. Haben mehr als die Hälfte der einander entsprechenden Bits den Pegel 0 (den Pegel 1), so wird entschieden, daß der Pegel des betreffenden Bits 0 (1) sein muß; haben weniger als Hälfte der einander entsprechenden Bits den Pegel 0 (den Pegel 1), so wird entschieden, daß der Wert des betreffenden Bits 1 (0) ist.

Selbstverständlich können die in der Speichereinrichtung zu speichernden Daten auch beliebig öfter als drei Mal in die Speichereinrichtung eingeschrieben werden.

Wenn sich der Speicherinhalt nur in eine bestimmte Richtung verändert, also nur Veränderungen des Speicherinhalts von 0 auf 1 oder umgekehrt stattfinden, reicht es aus, wenn die zu speichernden Daten zwei Mal in der Speichereinrichtung gespeichert werden. Ein unter einer Adresse x zu speicherndes Datum wird dann beispielsweise nicht nur unter der Adresse x, sondern automatisch zusätzlich unter der Adresse x+m gespeichert.

Wenn die gespeicherten Daten aus der Speichereinrichtung ausgegeben oder auf Fehlerfreiheit bzw. Unverändertheit überprüft und gegebenenfalls korrigiert werden sollen, werden die ursprünglich in die Speichereinrichtung eingespeicherten Daten aus den doppelt gespeicherten Daten rekonstruiert. Dabei werden die einander entsprechenden Daten (im betrachteten Beispiel die unter den Adressen x und x+m gespeicherten Daten) gelesen und bitweise ausgewertet. Haben die einander entsprechenden Bits den selben Pegel, so wird entschieden, daß der Pegel des betreffenden Bits der gemeinsame Pegel ist; haben die einander entsprechenden Bits unterschiedliche Pegel, so wird entschieden, daß der Pegel des betreffenden Bits 0 ist (wenn Speicherinhaltsveränderungen nur oder mit sehr hoher Wahrscheinlichkeit vom Pegel 0 auf den Pegel 1 erfolgen) bzw. daß der Pegel des betreffenden Bits 1 ist (wenn Speicherinhaltsveränderungen nur oder mit sehr hoher Wahrscheinlichkeit vom Pegel 1 auf den Pegel 0 erfolgen).

Wenn die Daten drei Mal oder öfter in der Speichereinrichtung gespeichert sind, wird zur Rekonstruktion der ursprünglich in die Speichereinrichtung eingeschriebenen Daten vorzugsweise ein Zähler vorgesehen, durch welchen gezählt wird, wie oft in den einander entsprechenden Bits der mehrfach gespeicherten Daten die 0 oder 1 vorkommt; abhängig vom Zählstand des Zählers wird dann entschieden, ob das betreffende Bit den Wert 0 oder 1 hat.

Auch wenn die Daten "nur" zwei Mal in der Speichereinrichtung gespeichert sind, kann ein Zähler zur Rekonstruktion der ursprünglich in die Speichereinrichtung eingeschriebenen Daten vorgesehen werden. Günstiger ist es in diesem Fall jedoch, die Rekonstruktion mittels einer einfachen Boolschen Operation wie beispielsweise einer UND-Operation durchzuführen. Unterzieht man die einander entsprechenden Bits der mehrfach gespeicherten Daten einer UND-Operation, so repräsentiert - wenn Speicherinhaltsveränderungen nur oder nur mit sehr hoher Wahrscheinlichkeit von 0 auf 1 erfolgen - das Ergebnis der UND-Operation den ursprünglichen Wert des betreffenden Bits; wenn Speicherinhaltsveränderungen nur oder nur mit sehr hoher Wahrscheinlichkeit von 1 auf 0 erfolgen, sind die Ein- und Ausgangssignale der UND-Operation zu invertieren oder eine ODER-Operation durchzuführen.

Die Rekonstruktion der ursprünglich in die Speichereinrichtung eingeschriebenen Daten mittels Boolscher Operationen kann auch in Fällen erfolgen, in welchen die in die Speichereinrichtung einzuschreibenden Daten öfter als zwei Mal in diese eingeschrieben werden.

Die wie beschrieben oder ähnlich rekonstruierten Daten stellen mit an Sicherheit grenzender Wahrscheinlichkeit die ursprünglich in die Speichereinrichtung eingespeicherten Daten dar. Sie können zur bestimmungsgemäßen Verwendung derselben aus der Speichereinrichtung ausgegeben werden oder zur Feststellung verwendet werden, ob und gegebenenfalls welche der in der Speichereinrichtung gespeicherten Daten fehlerhaft (verändert) sind.

Zur Feststellung, ob und gegebenenfalls welche der in der Speichereinrichtung gespeicherten Daten fehlerhaft (verändert) sind, werden die rekonstruierten Daten mit den in der Speichereinrichtung gespeicherten Daten verglichen. Unterschiede zwischen den rekonstruierten Daten und den in der Speichereinrichtung gespeicherten Daten treten bei Speicherelementen auf, die defekt sind oder deren Inhalt sich verändert hat. Diese Speicherelemente können sofort oder später mit den korrekten (rekonstruierten) Daten überschrieben werden; dadurch können defekte Speicherelemente erkannt und Speicherinhaltsveränderungen rückgängig gemacht werden.

Insbesondere bei Speichereinrichtungen, die wie beispielsweise die vorliegend näher betrachteten Flash-Speicher nur in größeren Einheiten (Sektoren) überschreibbar sind, erweist es sich als vorteilhaft, wenn erst alle innerhalb wenigstens eines Sektors vorhandenen Fehler ermittelt werden und anschließend in einem einzigen Überschreibvorgang korrigiert werden.

Die Rekonstruierung der ursprünglich in die Speichereinrichtung eingespeicherten Daten sowie die Ermittlung und Korrektur von fehlerhaften oder veränderten Daten innerhalb der Speichereinrichtung kann hardwaremäßig oder softwaremäßig erfolgen.

Eine softwaremäßige Realisierung erweist sich als vorteilhaft, weil sie auch in herkömmlichen (in nicht speziell für die beschriebenen Maßnahmen ausgelegten) Speichereinrichtungen zum Einsatz kommen kann.

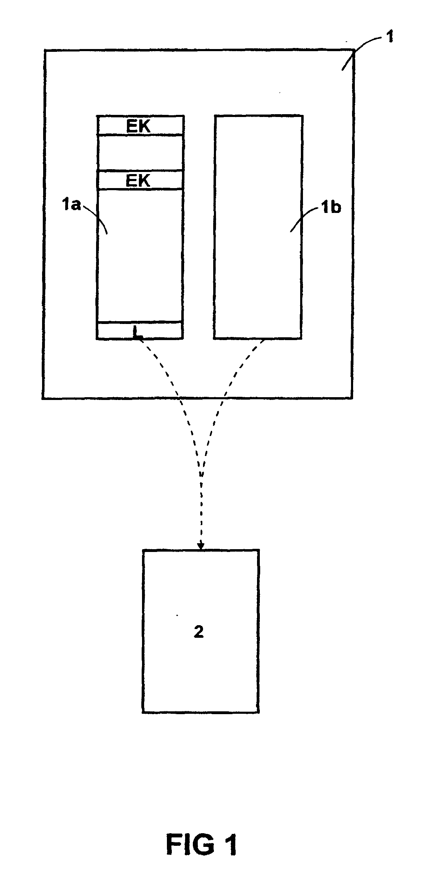

Eine Möglichkeit zur softwaremäßigen Realisierung wird nachfolgend unter Bezugnahme auf Figur 1 beschrieben.

Die Speichereinrichtung, für welche dies geschieht, ist in der Figur 1 mit dem Bezugszeichen 1 bezeichnet. Es handelt sich um den Programmspeicher des Mikrocontrollers.

Die Speichereinrichtung 1 ist so hergestellt, daß - wenn überhaupt - nur Speicherinhaltsveränderungen auftreten, bei welchen der Pegel 0 zum Pegel 1 wird. In diesem Fall reicht es aus, wenn in die Speichereinrichtung einzuspeichernde Daten zwei Mal in dieser gespeichert werden.

Dementsprechend ist die Speichereinrichtung 1 in zwei Bereiche unterteilt, nämlich den eigentlichen Programmspeicher 1a und ernen sogenannten Shadow-Speicher 1b. In die Speichereinrichtung 1 einzuschreibende Daten werden sowohl in den Programmspeicher 1a als auch in den Shadow-Speicher 1b eingeschrieben; der Shadow-Speicher 1b ist - wenn und so lange keine Speicherfehler und Speichinhaltsveränderungen vorliegen - eine exakte Kopie des Programmspeichers la.

Im Programmspeicher 1a sind ausführbare Programme (von der CPU des Mikrocontrollers ausführbare Programme) und eventuell zur Programmausführung benötigte Daten gespeichert. Im betrachteten Beispiel sind auch das oder die Programme zur Rekonstruierung der in die Speichereinrichtung eingeschriebenen Daten sowie zur Ermittlung und Korrektur von fehlerhaften oder veränderten Speicherinhalten im Programmspeicher 1a gespeichert; es sei jedoch bereits an dieser Stelle darauf hingewiesen, daß diese Programme auch in anderen Speichereinrichtungen (vorzugsweise in einem im Mikrocontroller enthaltenen ROM) gespeichert sein können.

Auszuführende Programme werden aus dem Programmspeicher 1a in einen Arbeitsspeicher 2 geladen und von dort aus zur Ausführung gebracht.

Im betrachteten Beispiel wird nach der Inbetriebnahme des Mikrocontrollers ein Programm zur Ermittlung und Korrektur von Datenfehlern und Speicherinhaltsveränderungen ausgeführt. Dieses Programm ist in Figur 1 mit dem Bezugszeichen EK bezeichnet. Dieses (im Programmspeicher 1a) gespeicherte Programm wird nach der Inbetriebnahme des Mikrocontrollers durch ein (ebenfalls im Programmspeicher 1a) gespeichertes Ladeprogramm L vom Programmspeicher la in den Arbeitsspeicher 2 transferiert und von dort aus zur Ausführung gebracht.

Das Ladeprogramm L führt beim Laden des Ermittlungs- und Korrekturprogrammes EK eine Rekonstruierung der dieses Programm repräsentierenden Daten durch. Damit dies mit einem möglichst geringen Aufwand erfolgen kann, ist das Ermittlungs- und Korrekturprogramm EK zwei Mal im Programmspeicher 1a gespeichert, und zwar vorzugsweise innerhalb des selben Sektors des Programmspeichers 1a.

Beim Laden des Ermittlungs- und Korrekturprogrammes EK in den Arbeitsspeicher 2 werden einander entsprechende Bits der im Programmspeicher 1a gespeicherten Fassungen des Ermittlungsund Korrekturprogrammes EK einer UND-Operation unterzogen und das Ergebnis dieser UND-Operation in den Arbeitsspeicher 2 geschrieben. Dadurch wird, wie vorstehend bereits erläutert wurde, erreicht, daß das Ermittlungs- und Korrekturprogramm EK in seiner ursprünglich in die Speichereinrichtung eingeschriebenen Fassung also fehlerfrei im Arbeitsspeicher 2 zu stehen kommt.

Das Ermittlungs- und Korrekturprogramm EK liest den Programmspeicher 1a und den Shadow-Speicher 1b aus und vergleicht die dabei erhaltenen Daten mit den ursprünglich in die Speichereinrichtung eingeschriebenen und wie vorstehend beschrieben rekonstruierbaren Daten und/oder die einander entsprechenden Daten miteinander. Dabei wird ermittelt, welche Daten innerhalb der Speichereinrichtung nicht den ursprünglich in diese eingeschriebenen Daten entsprechen. Die Daten, für welche dies der Fall ist, werden durch Überschreiben mit den korrekten (rekonstruierten) Daten korrigiert. Die Korrektur erfolgt insbesondere dann, wenn es sich wie bei dem vorliegend betrachteten Flash-Speicher um einen Speicher handelt, der nur im größeren Einheiten (segmentweise) überschreibbar ist, nicht sofort, sondern erst nach der Überprüfung eines, mehrerer oder aller Segmente. Für die als fehlerhaft ermittelten Daten werden dann die Adresse und der korrekte Wert im Arbeitsspeicher 2 zwischengespeichert.

Nach der Ausführung des Ermittlungs- und Korrekturprogrammes EK kann davon ausgegangen werden, daß alle in der Speichereinrichtung 1, d.h. sowohl die im Programmspeicher 1a als auch die im Shadow-Speicher 1b gespeicherten Daten fehlerfrei sind (den ursprünglich in die Speichereinrichtung eingeschriebenen Daten entsprechen).

Fehler sind mit an Sicherheit grenzender Wahrscheinlichkeit ausgeschlossen: durch die Rekonstruierung des Ermittlungsund Korrekturprogrammes EK vor dessen Verwendung ist auch ausgeschlossen, daß aufgrund von Fehlern im Ermittlungs- und Korrekturprogramm in der Speichereinrichtung 1 vorhandene Fehler unerkannt bleiben oder Fehler durch das Ermittlungsund Korrekturprogramm generiert werden. Nur das Ladeprogramm L muß auch ohne vorherige Rekonstruktion und Überprüfung fehlerfrei sein und ordnungsgemäß funktionieren, denn es kann vor dessen Ausführung nicht überprüft und korrigiert werden. Dies ist allerdings kein allzugroßes Problem, weil das Ladeprogramm L sehr kurz (beispielsweise nur etwa 40 Bytes lang) sein kann und somit die Wahrscheinlichkeit von Fehlern vernachlässigbar gering ist. Die Minimierung der Wahrscheinlichkeit des Auftretens von Fehlern innerhalb des Ladeprogrammes L ist übrigens der Grund dafür, daß das Ermittlungs- und Korrekturprogramm EK innerhalb des Programmspeichers 1a zwei Mal (also insgesamt vier Mal in der Speichereinrichtung 1) gespeichert ist; das doppelte Vorsehen des Ermittlungs- und Korrekturprogrammes innerhalb des Programmspeichers 1a (innerhalb eines Segments desselben) ermöglicht es, die Rekonstruktion des Ermittlungs- und Korrekturprogrammes EK unter Verwendung kürzerer und/oder einfacher handhabbaren Adressen durchzuführen als es der Fall wäre, wenn abwechselnd auf den Programmspeicher 1a und den Shadow-Speicher lb oder verschiedene Segmente innerhalb des Programmspeichers la zugegriffen werden müßte. Die Wahrscheinlichkeit von Fehlern im Ladeprogramm L läßt sich zusätzlich oder alternativ auch dadurch reduzieren, daß das Ladeprogramm L so geschrieben und/oder codiert ist, daß es hauptsächlich aus Einsen (für den Fall, daß Speicherinhaltsveränderungen nur oder mit allergrößter Wahrscheinlichkeit nur von 0 auf 1 erfolgen) oder Nullen (für den Fall, daß Speicherinhaltsveränderungen nur oder mit allergrößter Wahrscheinlichkeit nur von 1 auf 0 erfolgen) besteht.

Eine weitere Möglichkeit zur Rekonstruierung der ursprünglich in die Speichereinrichtung eingeschriebenen Daten und zur Ermittlung und Korrektur von fehlerhaften oder veränderten Daten in der Speichereinrichtung besteht darin, daß von den in der Speichereinrichtung zu speichernden Daten abhängende Zusatzinformationen generiert und zusätzlich zu den zu speichernden Daten gespeichert werden.

Die Zusatzinformationen können beispielsweise aus Paritätsbits gebildet werden, die für einen bestimmten Speicherbereich gebildet werden.

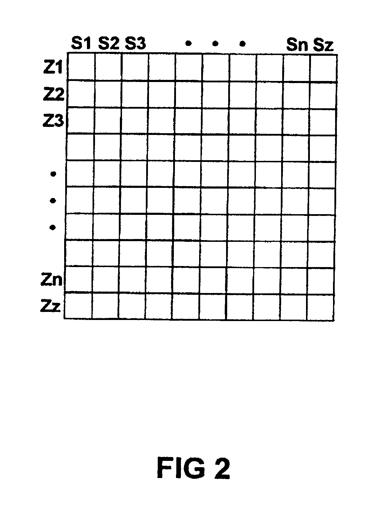

Dies ist schematisch in Figur 2 veranschaulicht.

Die Figur 2 zeigt eine Speichereinrichtung mit n+1 (Speicherelemente-)Zeilen und m+1 (Speicherelemente-)Spalten. Von den n+1 Zeilen (Zeilen Z1 bis Zn und Zz) sind n Zeilen, genauer gesagt die Zeilen Z1 bis Zn zur Speicherung von in der Speichereinrichtung zu speichernden Daten vorgesehen; die letzte Zeile Zz ist zur Speicherung der erwähnten Zusatzinformationen reserviert. Ähnliches gilt für die Spalten: Von den m+1 Spalten (Spalten S1 bis Sm und Sz) sind m Spalten, genauer gesagt die Spalten S1 bis Sm zur Speicherung von in der Speichereinrichtung zu speichernden Daten vorgesehen; die letzte Spalte Sz ist zur Speicherung der erwähnten Zusatzinformationen reserviert.

Die Zusatzinformationen bestehen im betrachteten Beispiel aus Paritätsbits. Es sei jedoch bereits an dieser Stelle darauf hingewiesen, daß die Zusatzinformationen auch beliebige andere Informationen als die Parität der eigentlich in der Speichereinrichtung zu speichernden Daten repräsentieren kann.

Die in der Zusatzzeile Zz gespeicherten Paritätsbits sind jeweils unter Berücksichtigung der in der betreffenden Spalte der Zeilen Z1 bis Zn gespeicherten Daten gebildet. D.h., das in Zeile Zz, Spalte Sa gespeicherte Paritätsbit hängt von den in der Spalte Sa der Zeilen Z1 bis Zn gespeicherten Daten ab.

Entsprechendes gilt für die in der Zusatzspalte Sz gespeicherten Paritätsbits: diese sind jeweils unter Berücksichtigung der in der betreffenden Zeile der Spalten S1 bis Sm gespeicherten Daten gebildet. D.h., das in Zeile Zb, Spalte Sz gespeicherte Paritätsbit hängt von den in der Zeile Zb der Spalten S1 bis Sm gespeicherten Daten ab.

Das in Zeile Zz, Spalte Sz gespeicherte Paritätsbit repräsentiert die Parität der in den Spalten S1 bis Sm der Zeile Zz und der in den Zeilen Z1 bis Zn der Spalte Sz gespeicherten Paritätsbits.

Bei einer Veränderung der in den Zeilen Z1 bis Zn und den Spalten S1 bis Sm gespeicherten Daten müssen die zugeordneten Paritätsbits aktualisiert werden.

Mittels der in der Zusatzzeile Zz und der in der Zusatzspalte Sz gespeicherten Paritätsbits kann dann jederzeit ermittelt werden, ob die in den Zeilen Z1 bis Zn und die in den Spalten S1 bis Sm gespeicherten Daten fehlerfrei sind. Ein gegebenenfalls vorhandener Fehler kann schnell und einfach lokalisiert und korrigiert werden; aus den gespeicherten Paritätsbits und den aus dem aktuellen Inhalt der Zeilen Z1 bis Zn und den Spalten S1 bis Sm ermittelten Paritätsbits läßt sich schnell feststellen, ob und gegebenenfalls wo (in welcher Zeile und in welcher Spalte) fehlerhafte Daten vorhanden sind. Ob die gespeicherten Paritätsbits fehlerfrei sind, läßt sich durch das in Zeile Zz, Spalte Sz gespeicherte Paritätsbit feststellen.

Durch die wie beschrieben erfolgende Erkennung und Korrektur von fehlerhaften Daten kann erreicht werden, daß nur fehlerfreie (rekonstruierte) Daten aus der Speichereinrichtung ausgegeben werden und/oder in dieser gespeichert sind.

Auf die beschriebene Art und Weise kann pro Zeile und pro Spalte ein Fehler erkannt und korrigiert werden. Dies mag insbesondere für Speichereinrichtungen mit großer Speicherkapazität (mit vielen Zeilen und/oder Spalten) als unzureichend erscheinen. Allerdings ist es frei festlegbar, wie viele Zeilen und/oder wie viele Spalten der Paritätsbit-Bildung zugrundegelegt werden; n und m sind unabhängig voneinander frei wählbar, so daß eine Speichereinrichtung in beliebig viele Speicherbereiche der in der Figur 2 gezeigten Art unterteilbar ist. Je kleiner n und/oder m sind, desto größer ist die Wahrscheinlichkeit, daß alle in der Speichereinrichtung vorhandenen Fehler erkannt und korrigiert werden können. Die Wahrscheinlichkeit, daß alle in der Speichereinrichtung vorhandenen Fehler erkannt und korrigiert werden können, läßt sich zusätzlich oder alternativ steigern, indem pro n Zeilen und-m Spalten mehrere (x) Zusatzzeilen und/oder Zusatzspalten vorgesehen werden, in welchen nicht nur das niederwertigste Bit der Quersumme, sondern die letzten x niederwertigsten Bits derselben gespeichert werden. Dann lassen sich pro Zeile und Spalte des zur Datenspeicherung verwendbaren Speicherbereiches auch mehr als ein Fehler erkennen und korrigieren.

Die pro Zeile und pro Spalte vorgesehenen Prüfbits müssen sich nicht auf alle Elemente der betreffenden Zeile oder Spalte beziehen. Es kann auch vorgesehen werden, daß die Prüfbits unter ausschließlicher Berücksichtigung von speziell ausgewählten Speicherelementen innerhalb der betreffenden Zeile oder Spalte gebildet werden. Diese speziell ausgewählten Speicherelemente sind vorzugsweise diejenigen Speicherelemente, die innerhalb der betreffenden Zeile oder Spalte am ehesten auszufallen oder ihren Inhalt zu verändern pflegen; Speicherelemente, die nie oder höchstwahrscheinlich nie oder zumindest nicht vor anderen Speicherelementen ausfallen oder ihren Inhalt ändern, können bei der Prüfbit-Bildung unberücksichtigt bleiben. Die Auswahl der zu berücksichtigenden Speicherelemente kann beispielsweise über eine Maske erfolgen.

Eine weitere Möglichkeit zur Handhabung von Speicherinhaltsveränderungen besteht darin, daß in der Speichereinrichtung (nur einfach und ohne Prüfbits) gespeicherte Daten nacheinander unter unterschiedlichen Bedingungen ausgelesen werden, und daß die ursprünglich eingespeicherten Daten aus den bei den verschiedenen Auslesevorgängen erhaltenen Daten rekonstruiert werden.

Die unterschiedlichen Auslesebedingungen sind im betrachteten Beispiel verschiedene Schwellenwerte, anhand welcher beim Auslesen der Speicherelemente entschieden wird, ob des im betreffenden Speicherelement gespeicherte Wert 0 oder 1 ist.

Bei Halbleiterspeichern wird der Inhalt eines Speicherelements häufig abhängig vom Potential der sogenannten Bitleitung bestimmt. Was bei Halbleiterspeichern die Bitleitung ist, ist allgemein bekannt und bedarf keiner näheren Erläuterung. Liegt das Bitleitungspotential diesseits des verwendeten Schwellenwertes, so wird entschieden, daß der Inhalt des betreffenden Speicherelements 0 ist; liegt das Bitleitungspotential jenseits des verwendeten Schwellenwertes, so wird entschieden, daß der Inhalt des betreffenden Speicherelements 1 ist.

Normalerweise liegt der Schwellenwert etwa in der Mitte zwischen dem Potential der Bitleitung, das diese bei einem Inhalt 0 des betreffenden Speicherelements annimmt und dem Potential der Bitleitung, das diese bei einem Inhalt 1 des betreffenden Speicherelements annimmt. Dieser Schwellenwert wird bei einem der beiden Auslesevorgänge verwendet.

Bei dem anderen Auslesevorgang wird ein Schwellenwert verwendet, der aus der Mitte verschoben ist. Dieser Schwellenwert ist vorzugsweise zu dem Potential hin verschoben, das die Bitleitung bei veränderbaren Speicherelementinhalten annimmt. Für das betrachtete Beispiel, bei welchem die Speichereinrichtung so aufgebaut ist, daß gegebenenfalls auftretende Speicherinhaltsveränderungen nur den Speicherinhalt 0 in den Speicherinhalt 1 (und nicht umgekehrt) verändern, bedeutet dies, daß der Schwellenwert mehr oder weniger nahe an dem Potential der Bitleitung liegt, welches diese bei einem Speicherelementinhalt 0 anzunehmen pflegt.

Wenn bei aufeinanderfolgenden Auslesevorgängen mit den verschiedenen Schwellenwerten Daten erhalten werden, die gleich sind, bedeutet dies, daß keine Speicherinhaltsveränderung bevorsteht. Wenn andererseits bei aufeinanderfolgenden Auslesevorgängen mit den verschiedenen Schwellenwerten Daten erhalten werden, die verschieden sind, so bedeutet dies, daß bei Verwendung des normalen Schwellenwertes demnächst mit einer Speicherinhaltsveränderung zu rechnen ist; die unterschiedlichen Daten, die bei Verwendung unterschiedlicher Schwellenwerte erhalten werden, signalisieren, daß der Speicherinhalt in Begriff ist, sich zu ändern.

Falls festgestellt wird, daß eine Speicherinhaltsveränderung bevorsteht, wird das betreffende Speicherelement vorzugsweise sofort mit den ursprünglich in die Speichereinrichtung eingeschriebenen Daten überschrieben. Die ursprünglich in die Speichereinrichtung eingeschriebenen Daten sind im betrachteten Fall diejenigen Daten, die erhalten werden, wenn diese unter Verwendung des normalen Schwellenwertes ausgelesen werden.

Wenn diese Art der Ermittlung und Korrektur von (bevorstehenden) Datenfehlern regelmäßig in kurzen Abständen wiederholt wird, so müssen die Daten im normalen Betrieb der Speichereinrichtung nicht bei jedem Auslesen auf Fehler überprüft werden; sie können unter Verwendung des normalen Schwellenwertes ausgelesen und ohne Überprüfung ausgegeben und verwendet werden.

Es kann selbstverständlich auch vorgesehen werden, die nacheinander erfolgenden Auslesevorgänge unter Verwendung von anders festgelegten Schwellenwerten auszulesen. Die Schwellenwerte müssen sich auch nicht auf eine Spannung bzw. ein Potential beziehen, sondern können auch andere physikalische Größen wie beispielsweise einen über die Bitleitung fließenden Strom oder einen durch das Bitleitungspotential im Leseverstärker oder anderswo hervorgerufenen Strom definieren.

Insbesondere bei der zuletzt beschriebenen-Möglichkeit, aber auch bei den anderen beschriebenen Möglichkeiten zur Handhabung von fehlerhaften oder veränderten Daten erweist es sich als vorteilhaft, wenn die Speichereinrichtung in kleinen Teileinheiten, beispielsweise in Einheiten von Zeilen oder Spalten überschrieben werden kann. Dabei können auch einzelne Zeilen oder Spalten innerhalb eines üblicherweise nur als eine zusammenhängende Einheit umzuprogrammierenden Speichereinrichtungs-Sektors umprogrammiert werden; bei einer solchen Umprogrammierung auftretende Beeinflussungen der nicht umprogrammierten Bestandteile des betreffenden Sektors sind in diesem Fall tolerierbar, weil sie ja bei Bedarf durch eine wie beschrieben erfolgende Überprüfung und Korrektur erkannt und beseitigt werden können. Bei einer derartigen Vorgehensweise kann der zur Zwischenspeicherung der in die Speichereinrichtung einzuschreibenden Daten benötigte Speicherplatz gering gehalten werden; bei zeilen- oder spaltenweiser Umprogrammierung genügt ein kleiner Pufferspeicher mit einer der Speicherkapazität der umzuprogrammierenden Zeile oder Spalte entsprechenden Speicherkapazität (beispielsweise 128 Bytes), was insbesondere dann, wenn die betreffende Speichereinrichtung wie im betrachteten Beispiel Bestandteil eines Mikrocontrollers ist, ein großer Vorteil ist.

Die verschiedenen Möglichkeiten zur Rekonstruierung der ursprünglich in die Speichereinrichtung eingeschriebenen Daten und zur Ermittlung und/oder Korrektur von fehlerhaften oder veränderten Speicherinhalten können beliebig miteinander kombiniert werden. Dabei erweist es sich insbesondere als vorteilhaft, wenn auch bei den beiden zuerst beschriebenen Möglichkeiten von der Variierbarkeit des Schwellenwertes beim Auslesen von Daten aus der Speichereinrichtung Gebrauch gemacht wird. Wenn bei der Ermittlung und Korrektur von fehlerhaften oder veränderten Speicherinhalten wenigstens ab und zu ein gegenüber dem normalen Schwellenwert verschobener Schwellenwert verwendet wird, lassen sich Speicherinhaltsveränderungen früher (schon im Anfangsstadium) und/oder zuverläsiger erkennen.

Die beschriebenen Möglichkeiten zum Umgang mit möglicherweise vorhandenen oder noch auftretenden Speicherfehlern und Speicherinhaltsveränderungen lassen sich unabhängig von den Einzelheiten der praktischen Realisierung schnell und einfach bereitstellen und durchführen.

### Bezugszeichenliste

- 1: Speichereinrichtung
- 1a: Programmspeicher
- 1b: Shadow-Speicher
- 2: Arbeitsspeicher

- EK: Ermittlungs- und Korrekturprogramm
- L: Ladeprogramm
- Sx: Spalten einer Speicherelemente-Matrix
- Zx: Zeilen einer Speicherelemente-Matrix

## Patentansprüche

1. Verfahren zum Betreiben einer Speichereinrichtung zum Speichern von Daten, wobei in der Speichereinrichtung zu speichernde Daten mehrfach in der Speichereinrichtung gespeichert werden, und wobei die ursprünglich eingespeicherten Daten bei Bedarf aus den mehrfach gespeicherten Daten rekonstruiert werden,
**dadurch gekennzeichnet,**
**daß** die Rekonstruktion der ursprünglich in die Speichereinrichtung eingespeicherten Daten unter Berücksichtigung der Richtung von gegebenenfalls vorkommenden Speicherinhaltsveränderungen erfolgt.

2. Verfahren nach Anspruch 1,
**dadurch gekennzeichnet,**
**daß** die Rekonstruktion der ursprünglich in die Speichereinrichtung eingespeicherten Daten eine Boolsche Operation umfaßt, welcher die einander entsprechenden Bits der mehrfach gespeicherten Daten unterzogen werden.

3. Speichereinrichtung zum Speichern von Daten, welche dazu ausgelegt ist, in der Speichereinrichtung zu speichernde Daten automatisch mehrfach in der Speichereinrichtung zu speichern, und die ursprünglich eingespeicherten Daten bei Bedarf aus den mehrfach gespeicherten Daten zu rekonstruieren,
**dadurch gekennzeichnet,**
**daß** diew Rekonstruktion der ursprünglich in die Speichereinrichtung eingespeicherten Daten unter Berücksichtigung der Richtung von gegebenenfalls vorkommenden Speicherinhaltsveränderungen erfolgt.

## Claims

1. Method for operating a memory device for storing data, where data which are to be stored in the memory device are stored in the memory device a plurality of times, and where the originally stored data are reconstructed as required from the data stored a plurality of times,
**characterized**
**in that** the data originally stored in the memory device are reconstructed taking into account the direction of any memory content changes which arise.

2. Method according to Claim 1,
**characterized**
**in that** the reconstruction of the data originally stored in the memory device comprises a Boolean operation to which the mutually corresponding bits of the data stored a plurality of times are subjected.

3. Memory device for storing data, which is designed to store data which are to be stored in the memory device automatically in the memory device a plurality of times and to reconstruct the originally stored data as required from the data stored a plurality of times,
**characterized**
**in that** the data originally stored in the memory device are reconstructed taking into account the direction of any memory content changes which arise.

## Revendications

1. Procédé pour exploiter un dispositif à mémoire pour mémoriser des données, dans lequel des données à mémoriser dans le dispositif à mémoire sont mémorisées plusieurs fois dans le dispositif à mémoire, et dans lequel les données mémorisées à l'origine sont reconstruites en cas de besoin, à partir des données mémorisées plusieurs fois,
**caractérisé en ce que**
la reconstruction des données mémorisées à l'origine dans le dispositif à mémoire se réalise en tenant compte du sens des altérations de contenu de mémoire qui se produisent éventuellement.

2. Procédé selon la revendication 1,
**caractérisé en ce que**
la reconstruction des données mémorisées à l'origine dans le dispositif à mémoire comprend une opération booléenne à laquelle sont soumis les bits qui se correspondent, des données mémorisées plusieurs fois.

3. Dispositif à mémoire pour mémoriser des données,
lequel est configuré de plus pour mémoriser automatiquement plusieurs fois des données à mémoriser dans le dispositif à mémoire, dans le dispositif à mémoire et pour reconstruire les données mémorisées à l'origine en cas de besoin à partir des données mémorisées plusieurs fois,
**caractérisé en ce que**
la reconstruction des données mémorisées à l'origine dans le dispositif à mémoire se réalise en tenant compte du sens des altérations de contenu de mémoire qui se produisent éventuellement.
